# EUROPÄISCHE PATENTSCHRIFT

(11) **EP 1 476 907 B1**
(45) Veröffentlichungstag und Bekanntmachung des Hinweises auf die Patenterteilung: **06.03.2019**
(21) Anmeldenummer: 03706232.0
(22) Anmeldetag: 20.01.2003
(51) Int. Cl.: H01L 41/083, H01L 41/047, H01L 41/29, H01L 41/27

(54) **PIEZOAKTOR MIT STRUKTURIERTER AUSSENELEKTRODE**
PIEZO ACTUATOR COMPRISING A STRUCTURED EXTERNAL ELECTRODE
ACTIONNEUR PIEZO-ELECTRIQUE A ELECTRODE EXTERNE STRUCTUREE

(30) Priorität: 22.02.2002 DE 10207530
(43) Veröffentlichungstag der Anmeldung: 17.11.2004
(73) Patentinhaber: TDK Electronics AG, 81671 München (DE)
(72) Erfinder: RIEMER, Steffen, 8510 Stainz (AT)
(74) Vertreter: Epping - Hermann - Fischer
(86) Internationale Anmeldenummer: PCT/DE2003/000141
(87) Internationale Veröffentlichungsnummer: WO 2003/073523

(56) Entgegenhaltungen:
- EP-A- 0 576 707
- EP-A- 1 162 671
- EP-A- 1 204 152
- EP-A- 1 239 525
- EP-A2- 1 065 735
- DE-A1- 19 740 570
- US-A- 4 523 121
- US-A- 5 406 164
- US-B1- 6 292 353

## Beschreibung

Die Erfindung betrifft ein elektrisches Vielschichtbauelement, insbesondere einen Piezoaktor. Ferner betrifft die Erfindung ein Verfahren zur Herstellung eines solchen elektrischen Vielschichtbauelements.

Es sind Piezoaktoren bekannt, die einen Grundkörper aufweisen, mit einem Stapel von übereinanderliegenden Keramikschichten und dazwischenliegenden Innenelektroden. Die Innenelektroden bestehen aus einer Mischung von Silber und Palladium. Die Keramikschichten enthalten eine Keramik auf der Basis von Blei-Zirkon-Titanat, welche aufgrund ihrer ferroelektrischen Eigenschaften einen piezoelektrischen Effekt aufweist. Aufgrund des piezoelektrischen Effekts dehnt sich die Keramik beim Anliegen einer elektrischen Spannung aus, wodurch Aktoren aus einer solchen Vielschichtkeramik gebildet werden können.

Bei den bekannten Piezoaktoren sind ferner Außenelektroden vorhanden, die durchgehend auf einer Seitenfläche des Grundkörpers aufgebracht sind und die Innenelektroden kontaktieren.

Aus den Druckschriften EP 1 065 735 A2 und DE 197 40 570 A1 gehen Piezoaktoren hervor, bei denen Außenelektroden in Form von Folien über Metallisierungsstreifen mit Innenelektroden elektrisch verbunden sind.

Um die Kosten für die Herstellung der Piezoaktoren zu reduzieren, wird es angestrebt, das Material der Innenelektroden sowie das Material der Außenelektrode durch Kupfer zu ersetzen. Bei den bekannten Piezoaktoren hat die Außenelektrode die Form einer durchgehenden Schicht. Diese Form der Außenelektrode ist für Außenelektroden aus Kupfer nicht geeignet.

Bei einer thermischen Belastung, wie sie beispielsweise beim Anlöten von Kontaktelementen an die Außenelektrode auftritt, ergibt sich bei einer durchgehenden Schicht eine Scherbelastung zwischen der Außenelektrode und dem Grundkörper des Piezoaktors, die dazu führt, daß die Grenzfläche zwischen der Außenelektrode und dem Grundkörper geschädigt wird. Diese Schädigung der Grenzfläche geht einher mit einer Verringerung der effektiven Haftfläche zwischen der Außenelektrode und dem Grundkörper.

Ein so hergestellter Piezoaktor ist im Laufe seines Einsatzes einer Vielzahl von mechanischen Dehnbelastungen ausgesetzt, welche ihrerseits wieder zu Scherspannungen zwischen dem Grundkörper und der Außenelektrode führen. Diese zusätzlichen Belastungen führen aufgrund der relativ hohen Stabilität der Kupferelektrode dazu, daß die bei der thermischen Belastung entstandenen Schädigungen sich flächig entlang der Grenzfläche ausbreiten und zu einer Ablösung der Außenelektrode führen. Damit fällt der Piezoaktor aus und kann nicht weiter verwendet werden.

Es ist Aufgabe der vorliegenden Erfindung ein elektrisches Vielschichtbauelement sowie ein Verfahren zu dessen Herstellung anzugeben, wobei die Gefahr des Ablösens der Außenelektrode vermindert werden soll.

Diese Aufgabe wird gelöst durch ein elektrisches Vielschichtbauelement nach Patentanspruch 1 sowie durch ein Verfahren zu dessen Herstellung nach Patentanspruch 12. Die weiteren Patentansprüche beziehen sich auf vorteilhafte Ausgestaltungen der Erfindung.

Es wird ein elektrisches Vielschichtbauelement angegeben, das einen Grundkörper umfaßt. Der Grundkörper enthält einen Stapel von übereinanderliegenden Keramikschichten und dazwischenliegenden Innenelektroden. An einer Seitenfläche des Grundkörpers ist eine Außenelektrode zur Kontaktierung von Innenelektroden aufgebracht.

Die Außenelektrode hat die Form einer Schicht, bei der wenigstens eine Vertiefung vorgesehen ist.

An der Stelle der Vertiefung kann die Dicke der Schicht vermindert sein. Dadurch entsteht an dieser Stelle eine Soll-Rißstelle, an der die Zug- und Druckfestigkeit der Schicht beziehungsweise der Außenelektrode vermindert ist. Dadurch genügen schon relativ kleine Scherbelastungen der Außenelektrode gegenüber dem Grundkörper, um an der Soll-Rißstelle einen Riß durch die Schicht zu erzeugen. Dadurch kann die auf die gesamte Schicht wirkende Scherbelastung deutlich verringert werden, da sich die die Scherbelastung erzeugenden Zugbeziehungsweise Druckspannungen entlang der Schicht beziehungsweise entlang der Oberfläche des Grundkörpers nur noch über einen entsprechend verkürzten Weg aufaddieren können.

Insbesondere kann die Schichtdicke an der Stelle der Vertiefungen ein lokales Minimum aufweisen.

Genauso ist es aber auch möglich, die Vertiefung in der Außenelektrode so auszuführen, daß die Außenelektrode an der Stelle der Vertiefung unterbrochen ist. Dadurch wird bereits bei der Herstellung der Außenelektrode gewissermaßen ein Riß vorgesehen, so daß sich von Haus aus keine großen Scherspannungen durch Addition von Zug- beziehungsweise Druckbelastungen über lange Strecken ergeben können.

Die Außenelektrode kann Bereiche mit im wesentlichen konstanter Schichtdicke aufweisen, was den Vorteil hat, daß die Außenelektrode durch ein Siebdruckverfahren aufgebracht werden kann.

Die Außenelektrode des elektrischen Vielschichtbauelements enthält Kupfer, wodurch die Materialkosten für das Bauelement reduziert werden können.

Desweiteren ist es vorteilhaft, wenn die Keramikschichten piezoelektrisch aktiv sind. Dies hat den Vorteil, daß das elektrische Vielschichtbauelement als Piezoaktor verwendet werden kann. Einen piezoelektrischen Effekt erhält man beispielsweise durch Verwendung einer Blei-Zirkonat-Titanatbasierten Keramik.

Die Vertiefungen können in Form von Gräben verlaufen, wobei die Gräben sich entlang einer Längsachse erstrecken. Die Projektion dieser Längsachsen auf die außenelektrodenseitige Seitenfläche des Stapels von übereinanderliegenden Keramikschichten beziehungsweise Innenelektroden schneidet die Innenelektroden in einem Winkel. Dadurch wird gewährleistet, daß jede entlang der entsprechenden Außenfläche des Stapels verlaufende Innenelektrode kontaktiert werden kann.

Dies bedeutet, daß der Winkel α einen von 0 und 180° verschiedenen Wert annimmt.

Es können vorteilhafterweise mehrere Vertiefungen äquidistant angeordnet sein. Dies hat den Vorteil, daß die Außenelektrode gleichmäßig in mehrere Bereiche unterteilt ist, was eine entsprechende Reduktion der maximalen auftretenden Scherspannung bedeutet.

Es können ferner mehrere Vertiefungen gleichmäßig über die Schicht verteilt sein.

Darüber hinaus ist es auch möglich, mehrere Vertiefungen so anzuordnen, daß sie eine periodisch wiederkehrende Struktur (zum Beispiel Raute, Quadrat) bilden.

Um die Funktion der Vertiefung als Soll-Rißstelle zu gewährleisten, ist es vorteilhaft, wenn die minimale Schichtdicke am Ort der Vertiefung maximal 75 % der Schichtdicke im Bereich der im wesentlichen konstanten Schichtdicke beträgt.

Die Außenelektrode ist in Form einer Siebdruckpaste, die Kupferpulver enthält, aufgebracht.

Das Aufbringen der Außenelektrode in Form einer Siebdruckpaste hat den Vorteil, daß durch das Verwenden entsprechender Siebdruckmasken eine sichere und gleichmäßige Anordnung von Vertiefungen mit einfachen Mitteln erreicht werden kann.

Bei dem Aufbringen der Außenelektrode in Form einer Siebdruckpaste beziehungsweise mittels eines Siebdruckverfahrens ist vorzugsweise darauf zu achten, daß die Vertiefungen eine minimale Breite von 200 *µ*m aufweisen, da ansonsten aufgrund der Konsistenz der Paste beziehungsweise der verwendeten Meshzahl eine definierte Vertiefung nicht mehr gewährleistet ist. Kleinere Vertiefungen lassen sich aufgrund der Dünnflüssigkeit der üblicherweise verwendeten Siebdruckpaste nur mit erhöhtem Aufwand realisieren. Es wäre jedoch denkbar, Vertiefungen mit kleineren lateralen Ausdehnungen zu erzeugen, indem eine strukturviskosere beziehungsweise thixotropere Siebdruckpaste verwendet wird.

Es wird darüber hinaus ein Verfahren zur Herstellung eines elektrischen Vielschichtbauelements angegeben, das folgende Schritte umfaßt:
a) Herstellen eines Grundkörpers mit einem Stapel von übereinanderliegenden Keramikschichten und dazwischenliegenden Innenelektroden sowie mit einer an einer Seitenfläche des Grundkörpers aufgebrachten Außenelektrode zur Kontaktierung von Innenelektroden, die die Form einer Schicht aufweist und bei der wenigstens eine Vertiefung vorgesehen ist.
b) Kontaktieren der Außenelektrode mit einem Kontaktelement unter Ausüben einer Scherbeanspruchung zwischen der Außenelektrode und der Seitenfläche des Grundkörpers.

Üblicherweise werden für die Keramikschichten und die Außenelektrode Materialien verwendet, deren thermische Ausdehnungskoeffizienten voneinander verschieden sind.

Das Verfahren zur Herstellung des elektrischen Vielschichtbauelements hat den Vorteil, daß trotz Ausüben der Scherbeanspruchung aufgrund der durch die Vertiefung gebildeten Soll-Rißstellen beziehungsweise bereits vorhandenen Risse die Gefahr der Ablösung der Außenelektrode vermindert ist.

Trotz der Verwendung von an ihre jeweilige Funktion angepaßter Materialien mit üblicherweise unterschiedlichem thermischen Ausdehnungskoeffizienten für Außenelektrode und Keramikschichten erlaubt es die Erfindung, daß das Kontaktieren der Außenelektrode mit einem Kontaktelement durch Löten erfolgt.

Bei Verwendung von Kupfer für die Außenelektrode und bei Verwendung einer PZT-Keramik für die Keramikschichten des Stapels kommt es in Betracht, das Löten bei einer Temperatur > 200° C durchzuführen, was die Verwendung entsprechend hochschmelzender Lote erlaubt. Solche hochschmelzenden Lote haben den Vorteil, daß sie den Einsatz des elektrischen Bauelements, beispielsweise des Piezoaktors, bei Temperaturen von bis zu 150° C erlauben, wie sie beispielsweise am Verbrennungsmotor eines Kraftfahrzeugs auftreten.

Im folgenden wird die Erfindung anhand von Ausführungsbeispielen und den dazugehörigen Figuren näher erläutert.
- Figur 1: zeigt beispielhaft ein elektrisches Vielschichtbauelement im schematischen Querschnitt
- Figur 2: zeigt eine weitere Ausführungsform einer Außenelektrode
- Figur 3: zeigt unterschiedliche Verläufe von Scherspannungen bei durchgehender und unterbrochener Außenelektrode
- Figur 4: zeigt Vertiefungen in Form von Gräben
- Figur 5: zeigt entlang eines regelmäßigen Gitters angeordnete Vertiefungen
- Figur 6: zeigt beispielhaft ein elektrisches Vielschichtbauelement, wobei am Rand des Grundkörpers eine Zwischenschicht ausgebildet ist.

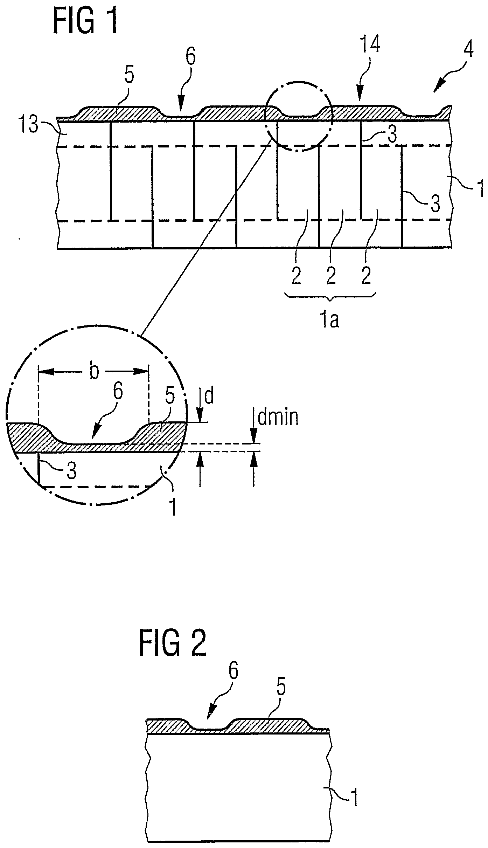

Figur 1 zeigt einen Piezoaktor, mit einem Grundkörper 1, der einen Stapel 1a von übereinanderliegenden Keramikschichten 2 und dazwischenliegenden Innenelektroden 3 enthält. Der Piezoaktor beziehungsweise der Grundkörper 1 ist liegend dargestellt. Grund- und Deckfläche des Stapels 1a befinden sich also auf der rechten beziehungsweise auf der linken Seite von Figur 1. Die Innenelektroden 3 reichen abwechselnd einmal bis zum oberen Rand beziehungsweise bis zum unteren Rand des Stapels 1a. Entlang von passiven Zonen 13 ist nur jede zweite Innenelektrode 3 vorhanden, so daß in dieser Zone nur eine sehr geringe Auslenkung des Piezoaktors bei Anlegen einer elektrischen Spannung zwischen den vom unteren Ende des Stapels 1a und den vom oberen Ende des Stapels 1a ausgehenden Innenelektroden 3 resultiert.

An der oberen Seitenfläche 4 des Grundkörpers 1 ist eine Außenelektrode 5 zur Kontaktierung von Innenelektroden 3 aufgebracht. Die Außenelektrode 5 ist mit Vertiefungen 6 versehen. Im Detail zu Figur 1 ist erkennbar, daß die Vertiefungen 6 in Form von lokalen Minima der die Form der Außenelektrode bestimmenden Schicht gegeben sind. Innerhalb der Vertiefung 6 weist die Schichtdicke d ein Minimum dₘᵢₙ auf. Desweiteren weist die Außenelektrode 5 Bereiche im wesentlichen konstanter Schichtdicke d auf, was bedeutet, daß in diesen Bereichen die Schichtdicke d um weniger als 10 % variiert. Ferner ist im Detail von Figur 1 zu erkennen, daß die Vertiefung 6 eine Breite b aufweist, welche bei Aufbringen der Außenelektrode 5 mittels Siebdruckverfahren ein gewisses Mindestmaß nicht unterschreiten soll, da ansonsten die üblicherweise verwendeten Siebdruckverfahren speziell angepaßt werden müssen, beispielsweise durch Verwenden einer strukturviskoseren Siebdruckpaste. Die minimale Schichtdicke dₘᵢₙ im Bereich der Vertiefung 6 soll höchsten 75 % der Schichtdicke d der Außenelektrode 5 betragen, da ansonsten die Funktion der Soll-Rißstelle nicht mehr gewährleistet ist.

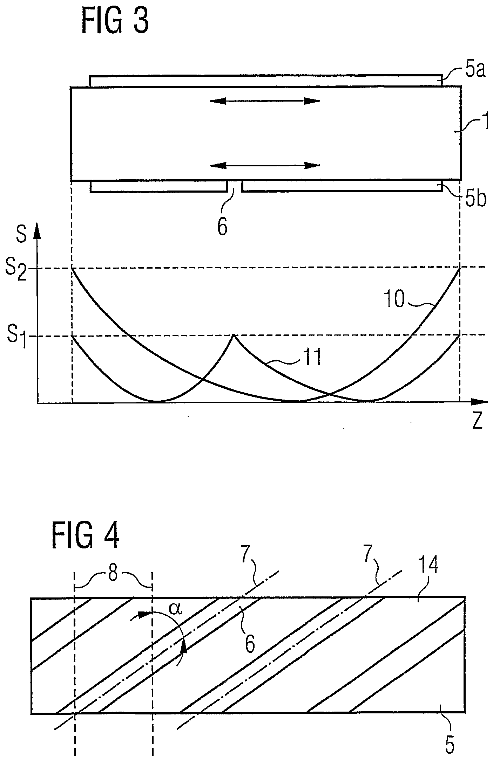

Ein weiteres Ausführungsbeispiel ist in Figur 2 beschrieben. Dort ist die Außenelektrode 5 an der Seitenfläche 4 des Grundkörpers 1 an der Stelle der Vertiefung 6 unterbrochen. Dies bedeutet, daß die Schichtdicke d im Bereich der Vertiefung 6 gleich Null ist. Diese Ausführungsform hat den Vorteil, daß die Außenelektrode 5 bei beispielsweise thermischer Belastung nicht erst am Ort der Soll-Rißstelle reißen muß, sondern daß die Unterbrechungen bereits vorhanden sind und die maximal auftretende Scherspannung schon von Haus aus reduziert ist (vgl. auch die Erläuterung zu Figur 3).

Figur 3 erläutert den Effekt, den das Unterbrechen einer Außenelektrode 5 auf die auftretenden Scherspannungen bei beispielsweise ausgelenktem Piezoaktor hat. Hierzu ist in Figur 3 der Grundkörper 1 eines Piezoaktors schematisch dargestellt. Die Auslenkung des Piezoaktors ist schematisch durch Doppelpfeile dargestellt. Auf der oberen Seite des Grundkörpers 1 ist eine durchgehende Außenelektrode 5a dargestellt. Auf der Unterseite des Piezoaktors beziehungsweise des Grundkörpers 1 ist eine mittels der Vertiefung 6 unterbrochene Außenelektrode 5b schematisch im Querschnitt dargestellt. Zieht man nun für die obere Außenelektrode 5a und die untere Außenelektrode 5b dieselbe Zugspannung (angedeutet durch die beiden Doppelpfeile) in Betracht, so gibt sich für den qualitativen Verlauf der Scherspannung S der unterhalb von Figur 3 gezeigte Verlauf. Dabei beschreibt die Kurve 10 den Verlauf der Scherspannung S in Abhängigkeit von der Längskoordinate z des Grundkörpers 1 für die durchgehende Außenelektrode 5a. Hingegen beschreibt die Kurve 11 den Verlauf der Scherspannung S in Abhängigkeit von der Längskoordinate z des Grundkörpers 1 für die unterbrochene Außenelektrode 5b. Da sich die Zug- beziehungsweise Druckspannungen im Fall der Außenelektrode 5a über einen längeren Weg addieren, entsteht für die Außenelektrode 5a auch die größere maximale Scherbeanspruchung, in Figur 3 mit S₂ gekennzeichnet. Bei der unterbrochenen Außenelektrode 5b kann sich die Zug- beziehungsweise Druckspannung nur über einen kürzeren Weg addieren, was dazu führt, daß, wie dem Verlauf der Kurve 11 zu entnehmen, eine geringere maximale Scherbeanspruchung S₁ resultiert. Diese niedrigere maximale Scherspannung führt dazu, daß die Gefahr des Abreißens der Außenelektrode 5b bei mechanischer Beanspruchung, beispielsweise durch Ziehen an mit der Außenelektrode 5b verbundenen Drähten oder auch durch eine Vielzahl von Auslenkungen des Piezoaktors, reduziert ist.

Eine günstige minimale Breite b beträgt zirka 200 *µ*m. Eine typischerweise durch Siebdruckverfahren herstellbare Schichtdicke d beträgt zirka 15 - 25 *µ*m.

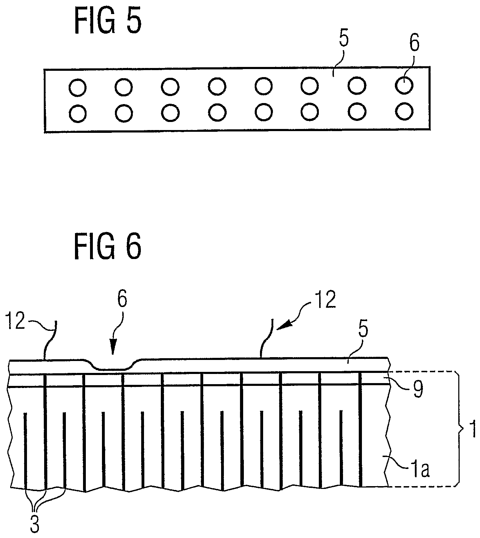

Figur 4 zeigt Vertiefungen 6 in einer Außenelektrode 5 in Form von entlang einer Längsachse 7 verlaufenden Gräben. Figur 4 ist eine Draufsicht auf eine beispielhafte Außenelektrode 5. Es sind ferner Linien 8 in Figur 6 gezeigt, die den Verlauf von den Innenelektroden 3 entsprechend Figur 1 symbolisieren. Die Längsachsen 7 verlaufen im wesentlichen zueinander parallel und schneiden die Linien 8 in einem Winkel α, der von 0° und 180° verschieden ist. Daraus ergibt sich, daß jede zweite Innenelektrode, welche durch Linien 8 repräsentiert sind, von Bereichen 14 mit im wesentlichen konstanter Schichtdicke d der Außenelektrode 5 kontaktiert werden. Dadurch kann sichergestellt werden, daß jede zweite Innenelektrode 3 von der Außenelektrode 5 beziehungsweise von Bereichen 14 mit im wesentlichen konstanter Schichtdicke der Außenelektrode 5 kontaktiert werden.

Figur 5 zeigt in Draufsicht ein weiteres Ausführungsbeispiel für eine strukturierte Außenelektrode 5. Dabei sind Vertiefungen 6 in Form von Kreisen vorgesehen, die ein quadratisches Gitter bilden.

Bei dem Aufbringen der Außenelektrode 5 in Form einer Siebdruckpaste wird üblicherweise eine Siebdruckpaste verwendet, die glasfrittehaltig ist. Diese Glasfritte wird verwendet, um die mechanische Anbindung der Außenelektrode 5 an den Grundkörper 1 zu verbessern. Je nach verwendeter Glasfritte und je nach verwendeter Keramik beziehungsweise abhängig von der Einstellung weiterer Prozeßparameter kann es vorkommen, daß die Glasfritte eine zwischen der Außenelektrode 5 und dem Rand des Grundkörpers 1 liegende, im Bereich der Innenelektroden 3 unterbrochene Zwischenschicht 9 bildet. Bei der Betrachtung des Problems des Abscherens beziehungsweise des Ablösens der Außenelektrode 5 ist die Zwischenschicht 9 aus Glasfritte dem Grundkörper 1 zuzuordnen, so wie es aus Figur 6 hervorgeht. Ablösungsprozesse finden bevorzugt zwischen der Außenelektrode 5 und der Zwischenschicht 9 statt.

Figur 6 zeigt außerdem zwei Kontaktelemente 12, die beispielsweise die Form von dünnen Drähten haben können und die durch Löten mit der Außenelektrode 5 verbunden sind. Bei Verwendung einer PZT-Keramik für die Keramikschichten mit einem thermischen Ausdehnungskoeffizienten von 1,5 - 2,0 x 10⁻⁶ m/mk und bei Verwendung einer Außenelektrode 5 aus Kupfer mit einem thermischen Ausdehnungskoeffizienten von 19 x 10⁻⁶ m/mk ergibt sich durch das Vorsehen der Vertiefungen 6 die Möglichkeit, das Anlöten der Kontaktelemente 12 bei einer Temperatur von zirka 300° C durchzuführen, was die Verwendung von hochschmelzenden Loten, beispielsweise von Pb-basierten Loten erlaubt.

Als Glasfritte kann beispielsweise eine Zusammensetzung verwendet werden, die Bleioxid, Siliziumoxid, Boroxid und gegebenenfalls weitere Bestandteile enthält.

Die vorliegende Erfindung beschränkt sich nicht auf die Verwendung bei Piezoaktoren sondern ist im Prinzip bei allen Vielschichtbauelementen, beispielsweise auch bei Kondensatoren anwendbar.

## Patentansprüche

1. Elektrisches Vielschichtbauelement
- mit einem Grundkörper (1)
- enthaltend einen Stapel (1a) von übereinanderliegenden Keramikschichten (2) und dazwischenliegenden Innenelektroden (3)
- bei dem an einer Seitenfläche (4) des Grundkörpers (1) eine Außenelektrode (5) zur Kontaktierung von Innenelektroden (3) aufgebracht ist,
- die die Form einer Schicht aufweist,
- bei der wenigstens eine Vertiefung (6) vorgesehen ist, **dadurch gekennzeichnet, dass**
- die Außenelektrode (5) in Form einer Siebdruckpaste, enthaltend Kupferpulver, aufgebracht ist.

2. Bauelement nach Anspruch 1,
bei dem die Außenelektrode (5) Bereiche (14) mit im wesentlichen konstanter Schichtdicke (d) aufweist.

3. Bauelement nach einem der Ansprüche 1 bis 2,
bei dem Keramikschichten (2) piezoelektrisch aktiv sind.

4. Bauelement nach einem der Ansprüche 1 bis 3,
bei dem die Vertiefungen (6) in Form von Gräben mit Längsachsen (7) verlaufen, und
bei dem die Projektion der Längsachsen (7) auf die außenelektrodenseitige Seitenfläche des Stapels (1a) die Innenelektroden (3) in einem Winkel α schneiden.

5. Bauelement nach einem der Ansprüche 1 bis 4,
bei dem mehrere Vertiefungen (6) äquidistant angeordnet sind.

6. Bauelement nach einem der Ansprüche 1 bis 5,
bei dem mehrere Vertiefungen (6) gleichmäßig über die Außenelektrode (5) verteilt sind.

7. Bauelement nach einem der Ansprüche 1 bis 6,
bei dem mehrere Vertiefungen (6) eine periodisch wiederkehrende Struktur bilden.

8. Bauelement nach einem der Ansprüche 1 bis 7,
bei dem die Schichtdicke (d) in Vertiefungen (6) ein lokales Minimum (dₘᵢₙ) aufweist.

9. Bauelement nach Anspruch 8,
bei dem dₘᵢₙ maximal 75 % der Schichtdicke (d) beträgt.

10. Bauelement nach einem der Ansprüche 1 bis 9,
bei dem die Außenelektrode (5) an den Vertiefungen (6) unterbrochen ist.

11. Bauelement nach einem der Ansprüche 1 bis 10,
bei dem die Vertiefungen (6) eine Breite (b) von mindestens 200 *µ*m aufweisen.

12. Verfahren zur Herstellung eines elektrischen Vielschichtbauelements nach einem der vorhergehenden Ansprüche mit folgenden Schritten:
a) Herstellen eines Grundkörpers (1) enthaltend einen Stapel (1a) von übereinanderliegenden Keramikschichten (2) und dazwischenliegenden Innenelektroden (3),
b) Aufbringen einer Kupfer enthaltenden Außenelektrode (5) zur Kontaktierung von Innenelektroden (3) an eine Seitenfläche (4) des Grundkörpers (1) durch ein Siebdruckverfahren in Form einer Schicht, bei der wenigstens eine Vertiefung (6) vorgesehen ist.

13. Verfahren nach Anspruch 12, aufweisend den weiteren Schritt:
c) Kontaktieren der Außenelektrode (5) mit einem Kontaktelement (12) unter Ausüben einer Scherbeanspruchung zwischen der Außenelektrode (5) und der Seitenfläche (4) des Grundkörpers (1).

14. Verfahren nach Anspruch 13,
wobei für die Außenelektrode (5) und die Keramikschichten (2) Materialien mit verschiedenen thermischen Ausdehnungskoeffizienten verwendet werden und wobei das Kontaktieren der Außenelektrode (5) mit einem Kontaktelement (12) durch Löten erfolgt.

15. Verfahren nach Anspruch 14,
wobei für die Außenelektrode Kupfer und für die Keramikschichten eine PZT-Keramik verwendet wird, und wobei zur Kontaktierung der Außenelektrode (5) Drähte durch Löten bei einer Temperatur > 200° C an die Außenelektrode (5) befestigt werden.

## Claims

1. Electrical multilayer component
- comprising a main body (1)
- containing a stack (1a) of ceramic layers (2) lying one above another and internal electrodes (3) lying therebetween,
- wherein an external electrode (5) for contacting internal electrodes (3) is applied at a side surface (4) of the main body (1),
- said external electrode having the form of a layer,
- wherein at least one depression (6) is provided, **characterized in that**
- the external electrode (5) is applied in the form of a screen printing paste, containing copper powder.

2. Component according to Claim 1,
wherein the external electrode (5) has regions (14) having a substantially constant layer thickness (d).

3. Component according to either of Claims 1 and 2, wherein ceramic layers (2) are piezoelectrically active.

4. Component according to any of Claims 1 to 3,
wherein the depressions (6) extend in the form of trenches having longitudinal axes (7), and
wherein the projection of the longitudinal axes (7) onto the side surface of the stack (1a) that is on the external electrode side intersects the internal electrodes (3) at an angle α.

5. Component according to any of Claims 1 to 4,
wherein a plurality of depressions (6) are arranged equidistantly.

6. Component according to any of Claims 1 to 5,
wherein a plurality of depressions (6) are distributed uniformly over the external electrode (5).

7. Component according to any of Claims 1 to 6,
wherein a plurality of depressions (6) form a periodically repeating structure.

8. Component according to any of Claims 1 to 7,
wherein the layer thickness (d) has a local minimum (dₘᵢₙ) in depressions (6).

9. Component according to Claim 8,
wherein dₘᵢₙ is a maximum of 75% of the layer thickness (d) .

10. Component according to any of Claims 1 to 9,
wherein the external electrode (5) is interrupted at the depressions (6).

11. Component according to any of Claims 1 to 10,
wherein the depressions (6) have a width (b) of at least 200 µm.

12. Method for producing an electrical multilayer component according to any of the preceding claims, comprising the following steps:
a) producing a main body (1) containing a stack (1a) of ceramic layers (2) lying one above another and internal electrodes (3) lying therebetween,
b) applying a copper-containing external electrode (5) for contacting internal electrodes (3) at a side surface (4) of the main body (1) by means of a screen printing method in the form of a layer, wherein at least one depression (6) is provided.

13. Method according to Claim 12, comprising the following further step:
c) contacting the external electrode (5) with a contact element (12) whilst exerting a shear stress between the external electrode (5) and the side surface (4) of the main body (1).

14. Method according to Claim 13,
wherein materials having different coefficients of thermal expansion are used for the external electrode (5) and the ceramic layers (2), and wherein contacting the external electrode (5) with a contact element (12) is carried out by soldering.

15. Method according to Claim 14,
wherein copper is used for the external electrode and a PZT ceramic is used for the ceramic layers, and wherein, for contacting the external electrode (5), wires are secured to the external electrode (5) by soldering at a temperature of > 200ºC.

## Revendications

1. Composant électrique multicouche
- comprenant un corps de base (1)
- contenant un empilement (1a) de couches de céramique superposées (2) et d'électrodes intérieures intermédiaires (3),
- dans lequel une électrode extérieure (5) destinée à venir en contact avec des électrodes intérieures (3) est appliquée sur une face latérale (4) du corps de base (1),
- laquelle électrode extérieure a la forme d'une couche
- dans laquelle au moins un évidement (6) est ménagé, **caractérisé en ce que**
- l'électrode extérieure (5) est appliquée sous la forme d'une pâte de sérigraphie contenant de la poudre de cuivre.

2. Composant selon la revendication 1,
dans lequel l'électrode extérieure (5) comporte des régions (14) ayant une épaisseur de couche sensiblement constante (d).

3. Composant selon l'une des revendications 1 à 2,
dans lequel les couches de céramique (2) sont actives du point de vue piézoélectrique.

4. Composant selon l'une des revendications 1 à 3,
dans lequel les évidements (6) s'étendent sous la forme de tranchées ayant des axes longitudinaux (7), et
dans lequel la projection des axes longitudinaux (7) sur la surface latérale côté électrode extérieure de l'empilement (1a) coupe les électrodes intérieures (3) selon un angle α.

5. Composant selon l'une des revendications 1 à 4,
dans lequel une pluralité d'évidements (6) sont ménagés de manière équidistante.

6. Composant selon l'une des revendications 1 à 5,
dans lequel une pluralité d'évidements (6) sont répartis uniformément sur l'électrode extérieure (5).

7. Composant selon l'une des revendications 1 à 6,
dans lequel une pluralité d'évidements (6) forment une structure périodiquement récurrente.

8. Composant selon l'une des revendications 1 à 7,
dans lequel l'épaisseur de couche (d) dans les évidements (6) présente un minimum local (dₘᵢₙ).

9. Composant selon la revendication 8,
dans lequel dₘᵢₙ représente au plus 75 % de l'épaisseur de couche (d).

10. Composant selon l'une des revendications 1 à 9,
dans lequel l'électrode extérieure (5) est interrompue au niveau des évidements (6).

11. Composant selon l'une des revendications 1 à 10,
dans lequel les évidements (6) ont une largeur (b) d'au moins 200 µm.

12. Procédé de fabrication d'un composant électrique multicouche selon l'une des revendications précédentes, comportant les étapes suivantes :
a) réaliser un corps de base (1) contenant un empilement (1a) de couches de céramique superposées (2) et d'électrodes intérieures intermédiaires (3),
b) appliquer une électrode extérieure (5), contenant du cuivre et destinée à venir en contact avec des électrodes intérieures (3), sur une surface latérale (4) du corps de base (1) par un procédé de sérigraphie sous la forme d'une couche dans laquelle est ménagé au moins un évidement (6).

13. Procédé selon la revendication 12, comprenant l'étape supplémentaire suivante:
c) mettre en contact l'électrode extérieure (5) avec un élément de contact (12) avec une contrainte de cisaillement entre l'électrode extérieure (5) et la surface latérale (4) du corps de base (1).

14. Procédé selon la revendication 13,
des matériaux ayant des coefficients de dilatation thermique différents étant utilisés pour l'électrode extérieure (5) et les couches de céramique (2), et la mise en contact de l'électrode extérieure (5) avec un élément de contact (12) étant effectuée par soudage.

15. Procédé selon la revendication 14,
dans lequel du cuivre est utilisé pour l'électrode extérieure et une céramique PZT est utilisée pour les couches céramiques et, des fils sont fixés à l'électrode extérieure (5) par soudage à une température > 200 °C pour venir en contact avec l'électrode extérieure (5).
